# EUROPEAN PATENT SPECIFICATION

(11) **EP 4 399 997 B1**
(45) Date of publication and mention of the grant of the patent: **21.10.2026**
(21) Application number: 23739943.1
(22) Date of filing: 09.01.2023
(51) Int. Cl.: A47B 9/00, H03K 17/96, H05K 5/00, H05K 5/02

(54) **CONTROL METHOD FOR ELECTRIC TABLE**
STEUERUNGSVERFAHREN FÜR EINEN ELEKTRISCHEN TISCH
PROCÉDÉ DE COMMANDE POUR TABLE ÉLECTRIQUE

(30) Priority: 14.01.2022 CN 202210043813
(43) Date of publication of application: 17.07.2024
(73) Proprietor: Zhejiang Jiecang Linear Motion Technology Co., Ltd., Shaoxing, Zhejiang 312500 (CN)
(72) Inventor: ZHOU, Jiling, Shaoxing, Zhejiang 312500 (CN); CHEN, Xueli, Shaoxing, Zhejiang 312500 (CN)
(74) Representative: karo IP
(86) International application number: PCT/CN2023/071171
(87) International publication number: WO 2023/134601

(56) References cited:
- WO-A1-2021/052083
- CN-A- 109 976 635
- CN-A- 112 299 279
- CN-A- 113 799 791
- CN-U- 212 258 929
- US-A1- 2017 364 197
- US-A1- 2017 364 197
- US-A1- 2022 286 131

## Description

### FIELD

The disclosure relates to electric desks, and more particularly relates to a method of controlling an electric desk.

### BACKGROUND

An electric desk as smart furniture is friendly to operate, which generally has a height adjustable feature, e.g., desktop flipping or moving up and down, or leg-driven moving up and down of the overall desk body. The electric desk is configured with a hand controller or an operation panel for a user to input a corresponding control instruction to perform control. Typical hand controllers or operation panels mostly perform control via a key, such as a touch key or a mechanical key.

The keys are substantially short-travel keys, so that sticking or short-circuiting likely occurs to the keys in circumstances such as collision. In operation, faults occurring to key control need to be taken into account: a short-circuited key would result in unintentional activation or shutdown failure, causing poor experience or accidents; due to safety hazards, it is needed to reduce the probability of faults. Although palm rejection-enabled hand controllers or pushbutton switches have emerged, their stability cannot satisfy practical use.

WO 2021/052083 A1 describes an operator for controlling electrically adjustable furniture. US 2017/364197 A1 describes touch operating methods, a touch operation assembly and an electronic device.

### SUMMARY

To overcome the drawbacks in conventional technologies, the disclosure provides a method of controlling an electric desk, so that the electric desk has a stable, reliable palm rejection feature to ensure user experience.

The disclosure adopts a technical solution below:
A method of controlling an electric desk, wherein the electric desk comprises a control device for controlling movement of the electric desk, the control device comprising a key, a chip module, and a controller, the control device further comprising a sensing element corresponding to the key, the sensing element being triggered by a key depressing action, the sensing element, when being triggered normally, emitting two independent trigger signals, the chip module being configured to receive the trigger signals such that the controller transmits a control instruction driving movement of the electric desk;
when the key is depressed, the control method comprises: S10: detecting, by a chip module, the trigger signals emitted from the sensing element, wherein if two trigger signals are detected, the control method proceeds to step S20, and otherwise proceeds to step S30; S20: transmitting, by a controller, the control instruction; S30: not transmitting, by a controller, the control instruction;
when the key is released, the control method comprises: T10: detecting, by the chip module, the trigger signals emitted from the sensing element, wherein if two trigger signals are detected, the control method proceeds to step T20, and otherwise proceeds to step T30; T20: maintaining, by the controller, the control instruction; T30: suspending, by the controller, the control instruction.

Based on the above solution, in the step S10, if the number of trigger signals detected by the chip module is one or zero, the method proceeds to step S30; in the step T10, if the number of trigger signals detected by the chip module is one or zero, the method proceeds to step T30.

Based on the above solution, the two trigger signals generated by the sensing element are referred to as a first signal and a second signal, respectively; in the step S10, the chip module detects the second signal after the first signal is detected; if the first signal is not detected, the method directly proceeds to step S30; in the step T10, the chip module detects the second signal after the first signal is detected; if the first signal is not detected, the method directly proceeds to step T30.

Based on the above solution, the controller issues the control instruction after the chip module detects the two trigger signals for consecutive two times; in the step S10, after the chip module consecutively detects two trigger signals within a unit time, the method proceeds to step S20; the unit time is 0.1s~2s.

The sensing element comprises a trigger element, and two triggering ends disposed on the trigger element and corresponding to the key, the two triggering ends, when contacting the key, generating one trigger signal, respectively.

Based on the above solution, the sensing element comprises a touch sensor and a pressure sensor; the touch sensor, after detecting a touch on the key, generates a trigger signal; and the pressure sensor, after detecting the key depressing action, generates a trigger signal.

Based on the above solution, the control device comprises a plurality of mechanical/touch keys and one common key, and by simultaneously depressing the common key and one mechanical/touch key, two trigger signals are generated.

Based on the above solution, the sensing element comprises a common trigger element corresponding to the common key and independent trigger elements corresponding to the mechanical/ touch keys; the common trigger element, when being triggered, generates a common signal; and the independent trigger elements, when being triggered, generate trigger signals; in the step S10, after the chip module detects the common signal and one trigger signal, the method proceeds to step S20; if the common signal and/or the trigger signal are not detected, the method proceeds to step S30; if a plurality of trigger signals are detected, the method proceeds to step S30; and in the step T10, after the chip module detects the common signal and one trigger signal, the method proceeds to step T20; if the common signal and/or trigger signal are not detected, the method proceeds to step T30; if a plurality of trigger signals are detected, the method proceeds to step T30.

Based on the above solution, the control device comprises a plurality of keys; the sensing element comprises one common trigger element and a plurality of independent trigger elements, the one common trigger element and the plurality of independent trigger elements being set in correspondence to the plurality of keys; when a key is depressed, the common trigger element and an independent trigger element are simultaneously triggered to generate two trigger signals.

Based on the above solution, the common trigger element, when being triggered, generates a common signal, and the independent trigger elements, when being triggered, generate trigger signals; in the step S10, after the chip module detects the common signal and one trigger signal, the method proceeds to step S20; if no common signal and/or trigger signal are detected, the method proceeds to step S30; if a plurality of trigger signals and/or a plurality of common signals are detected, the method proceeds to step S30; in the step T10, after the chip module detects the common signal and one trigger signal, the method proceeds to step T20; if no common signal and/or trigger signal are detected, the method proceeds to step T30; if a plurality of trigger signals and/or a plurality of common signals are detected, the method proceeds to step T30.

The disclosure offers the following benefits:
The disclosure discloses a method of controlling an electric desk; the control device of the electric desk may be a hand controller, a remote controller paired with the electric desk, or a control panel provided on the electric desk. In normal operation, when a key on the control device is depressed, the sensing element emits two independent trigger signals which do not interfere with each other. The chip module detects the two trigger signals; upon detection of the two trigger signals, the controller issues a control instruction driving movement of the electric desk; otherwise, the controller does not issue the control instruction. After the user releases the key, the sensing element suspends generation of the trigger signals, so that the chip module, which fails to detect the two trigger signals, suspends issuing of the control instruction. The disclosure adopts a dual-channel activation and dual-channel detection manner; compared with a single-channel detection manner adopted in conventional technologies, the solution disclosed herein is more stable and can reduce failure probability incurred by chip module pin faults.

When the key is unintentionally depressed, the sensing element might generate a trigger signal due to depressing of the key; however, since the key is touched unintentionally, the sensing element can hardly be fully triggered to generate two trigger signals; therefore, the controller would not generate a control instruction to cause the electric desk to perform an unintentional action; as such, the control device has a palm rejection feature, which enhances user experience.

To control the electric desk to stop movement, the user releases the key to thereby stop trigering the sensing element via the key, which may suspend generation of a trigger signal; after the trigger signal disappears, the chip module fails to detect two trigger signals, so that the controller suspends the control instruction, and the electric desk maintains stationary. If the released key is jammed so that the key cannot be reset, the trigger signal would be continuously generated and movement of the electric desk cannot be stopped. In this disclosure, the controller requires joint action of two trigger signals to maintain the control instruction; therefore, in the disclosure, failure to suspend the control instruction only occurs when the key is completely jammed; in most cases, even if the key is partially jammed, the sensing element still cannot be fully triggered to generate two trigger signals; as such, the user needn't worry that the control instruction cannot be suspended after the jammed key is released. Compared with conventional technologies, the solution of this disclosure offers a higher stability.

Furthermore, in the step S10, if the number of trigger signals detected by the chip module is one or zero, the method proceeds to step S30; in the step T10, if the number of trigger signals detected by the chip module is one or zero, the method proceeds to step T30. The chip module can detect the two trigger signals separately; when the key is unintentionally touched, the sensor element would not be fully triggered so that it might only generate one trigger signal; when the number of trigger signals detected by the chip module is one or zero, the controller would be unable to generate a control instruction; this may prevent the electric desk from moving in a case that the key is unintentionally touched.

Furthermore, the two trigger signals generated by the sensing element are referred to as a first signal and a second signal, respectively; in the step S10, the chip module detects the second signal after the first signal is detected; if the first signal is not detected, the method directly proceeds to step S30; in the step T10, the chip module detects the second signal after the first signal is detected; if the first signal is not detected, the method directly proceeds to step T30. The chip module is only activated to detect the second signal after the first signal is generated; if only the second signal is generated, the detection function of the chip module cannot be activated, which may reinforce the palm rejection function of the key, reduce the operating time of the chip module, and extend the service life of the chip module.

Furthermore, the controller issues the control instruction after the chip module detects the two trigger signals for consecutive two times; in the step S10, after the chip module consecutively detects two trigger signals within a unit time, the method proceeds to step S20; the unit time is 0.1s~2s. With this setting, if the key is pressed down by a foreign object, the sensing element would not be fully triggered, so that two trigger signals cannot be generated, and the controller cannot generate a control instruction; the controller can only generate a control instruction when the sensing element is triggered for consecutive two times within a unit time to generate two trigger signals in two times, thereby raising the criterion on control instruction generation and enhancing reliability of the palm rejection function of the electric desk.

Furthermore, the sensing element comprises a trigger element, and two triggering ends disposed on the trigger element to correspond to the key, the two triggering ends, when contacting the key, generating one trigger signal, respectively. Two trigger signals may be generated only by depressing one key, which facilitates user operation; when the key contacts one triggering end, one trigger signal may be generated; when the key contacts the two triggering ends, two trigger signals may be generated, i.e., the sensing element is fully triggered.

Furthermore, the sensing element comprises a touch sensor and a pressure sensor; the touch sensor, after detecting a touch on the key, generates a trigger signal; and the pressure sensor, after detecting the key depressing action, generates a trigger signal. The touch sensor may detect a contact between a human body and a key; unintentional key contact generally occurs when the key is depressed by a foreign object under its own gravity. When the foreign object contacts the key, only the pressure sensor is triggered, and the touch sensor, which fails to detect a touch, will not generate a corresponding trigger signal, thereby preventing generation of a control instruction.

Furthermore, the control device comprises a plurality of mechanical/touch keys and one common key, and by simultaneously depressing the common key and one mechanical/touch key, two trigger signals are generated. The plurality of mechanical/touch keys may correspond to different control instructions. Two trigger signals can be generated only when the mechanical/touch key and the common key are simultaneously depressed, which raises the difficulty in unintentional touch-activated movement of the electric desk. With provision of the plurality of keys, if each key were configured with two trigger elements, the chip module would require more pins to enable signal detection to the two trigger elements of each of the plurality of keys. However, setting of the common key may significantly reduce the number of pins of the chip module without affecting the palm rejection function of the hand controller.

Furthermore, the sensing element comprises a common trigger element corresponding to the common key and independent trigger elements corresponding to the mechanical/ touch keys; the common trigger element, when being triggered, generates a common signal; and the independent trigger elements, when being triggered, generate trigger signals; in the step S10, after the chip module detects the common signal and one trigger signal, the method proceeds to step S20; if the common signal and/or the trigger signal are not detected, the method proceeds to step S30; if a plurality of trigger signals are detected, the method proceeds to step S30; and in the step T10, after the chip module detects the common signal and one trigger signal, the method proceeds to step T20; if the common signal and/or trigger signal are not detected, the method proceeds to step T30; if a plurality of trigger signals are detected, the method proceeds to step T30. Detection of the common signal and one trigger signal indicates one mechanical/touch key and the common key are operated by the user; the controller generates a control instruction corresponding to the mechanical/touch key; when pluralities of trigger signals occur, it means a plurality of mechanical/ touch keys are triggered, which will be deemed as an unintentional touch.

Furthermore, the control device comprises a plurality of keys; the sensing element comprises one common trigger element and a plurality of independent trigger elements, the one common trigger element and the plurality of independent trigger elements being set in correspondence to the plurality of keys; when a key is depressed, the common trigger element and an independent trigger element are simultaneously triggered to generate two trigger signals. In normal operation, when one key is depressed, the common trigger element and one independent trigger element may be simultaneously depressed to generate two trigger signals. Therefore, the user only needs to depress one key, which facilitates operation. In a case of a plurality of keys being provided, if each key were provided with two trigger elements, the chip module would be set with more pins to enable signal detection to the two trigger elements of each of the plurality of keys. However, by setting the common key, the number of pins of the chip module may be significantly reduced without affecting the palm rejection function of the hand controller.

Furthermore, the common trigger element, when being triggered, generates a common signal, and the independent trigger elements, when being triggered, generate trigger signals; in the step S10, after the chip module detects the common signal and one trigger signal, the method proceeds to step S20; if no common signal and/or trigger signal are detected, the method proceeds to step S30; if a plurality of trigger signals and/or a plurality of common signals are detected, the method proceeds to step S30; in the step T10, after the chip module detects the common signal and one trigger signal, the method proceeds to step T20; if no common signal and/or trigger signal are detected, the method proceeds to step T30; if a plurality of trigger signals and/or a plurality of common signals are detected, the method proceeds to step T30. Detection of the common signal and one trigger signal indicates one key is operated by the user, and the controller generates a control instruction corresponding to the key; when a plurality of trigger signals and/or a plurality of common signals emerge, it indicates a plurality of keys are simultaneously triggered, which is determined as an unintentional contact action.

The above features and advantages of the disclosure will be described in detail through the specific examples with reference to the accompanying drawings.

### BRIEF DESCRIPTION OF THE DRAWINGS

Hereinafter, the disclosure will be further illustrated with reference to the accompanying drawings:
Fig. 1 is a structural schematic diagram of a key and a sensing element in some example embodiments of the disclosure;
Fig. 2 is schematic diagram A of detection and control manners of a chip module in some example embodiments of the disclosure;
Fig. 3 is a schematic diagram B of detection and control manners of a chip module in some example embodiments of the disclosure;
Fig. 4 is a schematic diagram C of detection and control manners of a chip module in some example embodiments of the disclosure;
Fig. 5 is a schematic diagram D of detection and control manners of a chip module in some example embodiments of the disclosure;
Fig. 6 is a schematic diagram E of detection and control manners of a chip module in some example embodiments of the disclosure;
Fig. 7 is a structural schematic diagram of a control device with a common key in some example embodiments of the disclosure;
Fig. 8 is a structural schematic diagram of a control device in some example embodiments of the disclosure.

### Reference Numerals

key 100; common key 110; touch/mechanical key 120;
sensing element 200; triggering end 210;
common trigger element 300; independent trigger element 310.

### DETAILED DESCRIPTION OF EMBODIMENTS

Hereinafter, the technical solutions of the disclosure will be explained and illustrated through embodiments with reference to the accompanying drawings. The scope of protection is defined solely by the appended claims.

The terms such as "exemplary" and "some example embodiments" referred to herein intend to mean "as an example, as an example implementation, or as an illustration"; no embodiments illustrated exemplarily shall be interpreted as preferred to or better than other embodiments. To better illustrate the disclosure, various details will be given in specific embodiments described infra; those skilled in the art shall understand that without some details, the disclosure can also be implemented.

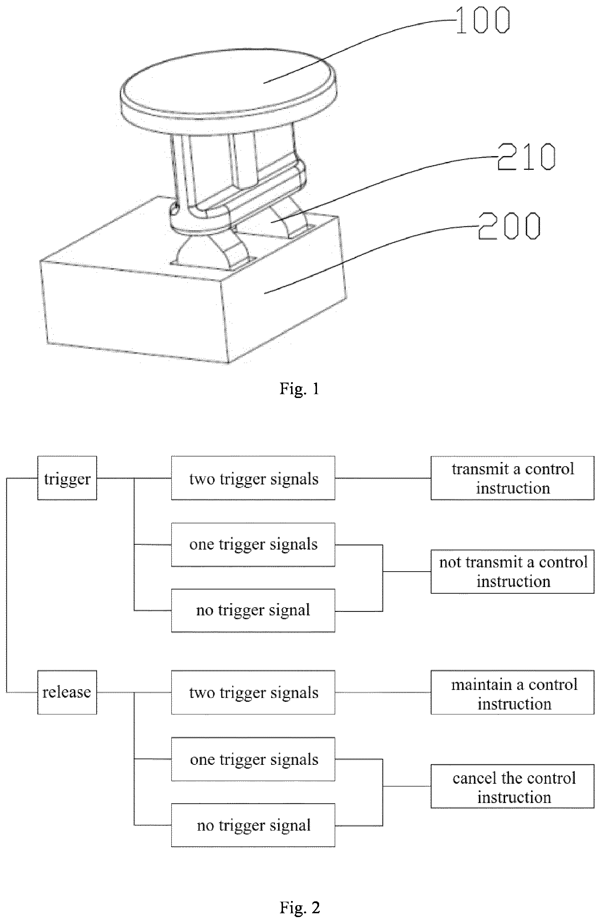

Refer to Figs. 1 and 2, embodiments of the disclosure disclose a method of controlling an electric desk, the electric desk comprising a control device controlling movement of the electric desk, the control device comprising a key 100, a chip module, and a controller, the control device further comprising a sensing element 200 corresponding to the key, the sensing element 200 being triggered by depressing the key 100, the sensing element 200 emitting two independent trigger signals in a case of being normally triggered, the chip module being configured to receive the trigger signals such that the controller transmits a control instruction driving movement of the electric desk.

When the key 100 is depressed, the control method comprises:
S10: trigger signals emitted from the sensing element are detected by the chip module; if two trigger signals are detected, the method proceeds to step S20; otherwise, the method proceeds to step S30;
S20: the controller transmits a control instruction;
S30: the controller shuns from transmitting a control instruction.

When the key 100 is released, the control method comprises:
T10: a trigger signal emitted from the sensing element is detected by the chip module; if two trigger signals are detected, the method proceeds to step T20; otherwise, the method proceeds to step T30;
T20: the controller maintains the control instruction;
T30: the controller suspends the control instruction.

The disclosure discloses a method of controlling an electric desk; the control device of the electric desk may be a hand controller, a remote controller paired with the electric desk, or a control panel provided on the electric desk. In normal operation, when the key 100 on the control device is depressed, the sensing element 200 emits two independent trigger signals which do not interfere with each other. The chip module detects the two trigger signals; upon detection of the two trigger signals, the controller issues a control instruction driving movement of the electric desk; otherwise, the controller does not issue a control instruction. After the user releases the key 100, the sensing element 200 suspends generation of trigger signals, so that the chip module, which fails to detect the two trigger signals, suspends the control instruction issued. The disclosure adopts a dual-channel activation and dual-channel detection manner; compared with a single-channel detection manner adopted in conventional technologies, the solution disclosed herein is more stable and can reduce failure probability incurred by chip module pin faults.

When the key 100 is unintentionally depressed, the sensing element 200 may generate a trigger signal due to depressing of the key 100; however, since the key 100 is unintentionally touched, the sensing element 200 can hardly be fully triggered to generate two trigger signals; therefore, the controller would not generate a control instruction resulting in unintentional movement of the electric desk; as such, the control device has a palm rejection feature, which enhances user experience.

To control the electric desk to stop movement, the user releases the key 100 to stop the key 100 from triggering the sensing element 200, thereby suspending generation of a trigger signal. After the trigger signal disappears, the chip module fails to detect two trigger signals, and the controller would stop the control instruction, whereby the electric desk maintains stationary. If the released key 100 is jammed from being reset, the trigger signal might be constantly generated and movement of the electric desk cannot be stopped. In this disclosure, the controller requires joint action of two trigger signals to maintain the control instruction; therefore, in the disclosure, the control instruction cannot be suspended only when the key 100 released is completely jammed; in most cases, even if the key 100 is partially jammed, the sensing element 200 still cannot be triggered to generate two trigger signals; therefore, the user needn't worry that the control instruction cannot be suspended due to jamming of the released key 100. Compared with conventional technologies, the solution of this disclosure offers a higher stability.

Exemplarily, an actual use process goes like this: to lift the desktop of the height adjustable desk upward by a certain distance, the user selects to control the UP key on the control device; by depressing the key, the sensing element emits two trigger signals; when two trigger signals are detected by the chip module, the controller issues a control instruction controlling the desktop to move upward; after the desktop rises to a desired height, the user releases the key so that the key is reset, and at least one of the trigger signals is interrupted; after the number of signals received by the chip module is less than two, the control instruction is immediately cancelled.

Specifically, in step S10 of the control method noted *supra,* if the number of trigger signals detected by the chip module is one or zero, the process proceeds to step S30;
in step T10: if the number of trigger signals detected by the chip module is one or zero, the process proceeds to step T30.

The chip module can detect the two trigger signals separately. When the key 100 is unintentionally touched, the sensor element 200 would not be fully triggered so that it might only generate one trigger signal; when the number of trigger signals detected by the chip module is one or no trigger signal is detected, the controller would be unable to generate a control instruction; this may prevent the electric desk from motion if the key is unintentionally touched.

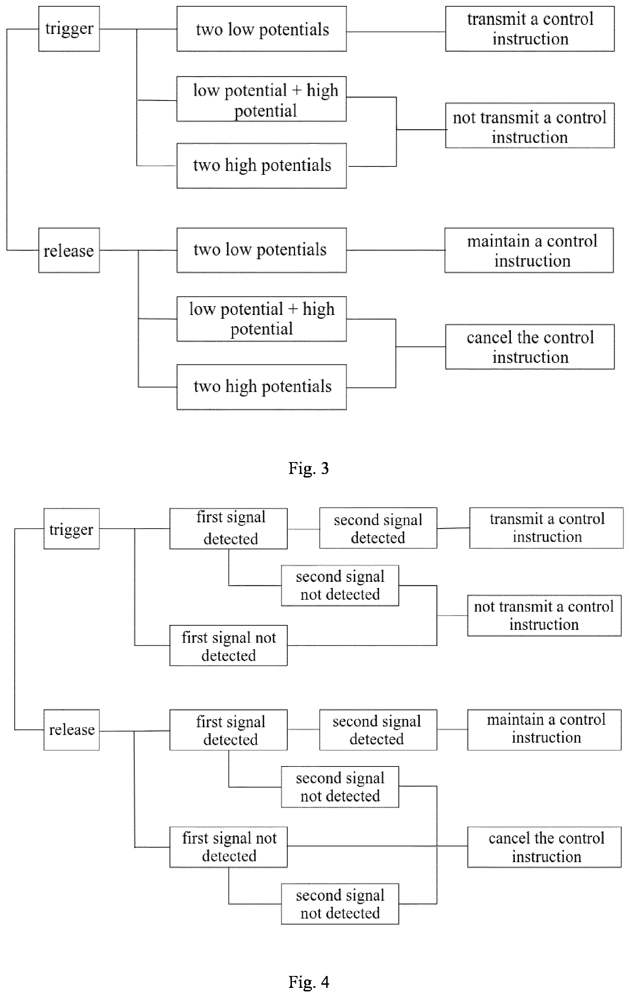

Refer to Figs. 1 and 3, in an example embodiment of the disclosure, the trigger signal is a potential change signal of the sensing element 200 from a high potential to a low potential, the potential of the sensing element 200 being changed by pressing or releasing the key 100.

The key 100 is a mechanical key, and the sensing element 200 is a dual-head tactile switch. The dual-head tactile switch comprises a trigger element, and two triggering ends 210 disposed on the trigger element and corresponding to the key 100; a trigger signal may be generated when the key 100 touches any triggering end 210. In normal operation, the depressed key 100 may simultaneously contact the two triggering ends 210 to generate two trigger signals, so that two trigger signals may be generated by only depressing one key 100, which facilitates user operation. The two triggering ends 210 are initially set with a high potential; when being depressed, the high potential becomes low potential; when the potential change signal generated due to potential change is detected by the chip module, it may be known that the triggering ends 210 are triggered; although the triggering ends 210 resume the high potential from the low potential after the key 100 is reset, since the information represented by the potential signal currently generated is different, even if the chip module receives such a potential signal, it would not be deemed as a trigger signal; so long as the depressed key 100 is released, the trigger signal would disappear, whereby the hand controller stops driving the electric desk.

A specific detection scenario is described as follows:
Depressing the key 100 would result in three consequences: two low-potential signals, two high-potential signals, and one low-potential signal + one high-potential signal; a control instruction is only transmitted when two low-potential signals are detected, while in the rest two consequences, no control instruction is transmitted;
Releasing the key 100 would also result in three consequences: two low-potential signals, two high-potential signals, and one low-potential signal + one high-potential signal; validity of the control instruction is maintained only when two low-potential signals are detected; while in the rest two consequences, the control instruction would be cancelled.

The key may be one that moves downward when being depressed and reset when being released, or one which is locked after being depressed for the first time and reset after being depressed for the second time. For the second type of key, after the first time of depressing ends, the sensing element may be held at the triggered state to continuously emittrigger signals, thereby maintaining validity of the control instruction; the potential state of the sensing element is on changed after the second time of depressing.

Refer to Figs. 1 and 4, based on the example embodiments noted *supra,* in one example embodiment, the two trigger signals are referred to as a first signal and a second signal, respectively. In step S10, the chip module detects a second signal after the first signal is detected, and if the first signal is not detected, the process directly goes to step S30; in step T10, the chip module detects the second signal after the first signal is detected; if the first signal is not detected, the process directly goes to step T30. The chip module is activated to detect the second signal only after the first signal is generated; if only the second signal is generated, the detection feature of the chip module cannot be activated, which may enhance the palm rejection function of the key, reduce operating time of the chip module, and extend the service life of the chip module.

Different from the example embodiments noted *supra,* in another example embodiment of the disclosure, to enhance reliability of the palm rejection feature of the electric desk, the controller issues a control instruction after the chip module detects two trigger signals for consecutively two times; if the two trigger signals are consecutively detected by the chip module within a unit time in step S10, the method goes to step S20, where the unit time is 0.1s~2s. With this setting, even if the key is depressed by a foreign object and the sensing element is fully triggered to generate two trigger signals, the controller still cannot generate a control instruction; the controller can generate a control instruction only when the sensing element is fully triggered for consecutive two times within a unit time with two trigger signals being generated for two times; this raises the criteria on generating a control instruction. Even if four trigger signals are generated by depressing the key for consecutively three times, a control instruction still cannot be generated.

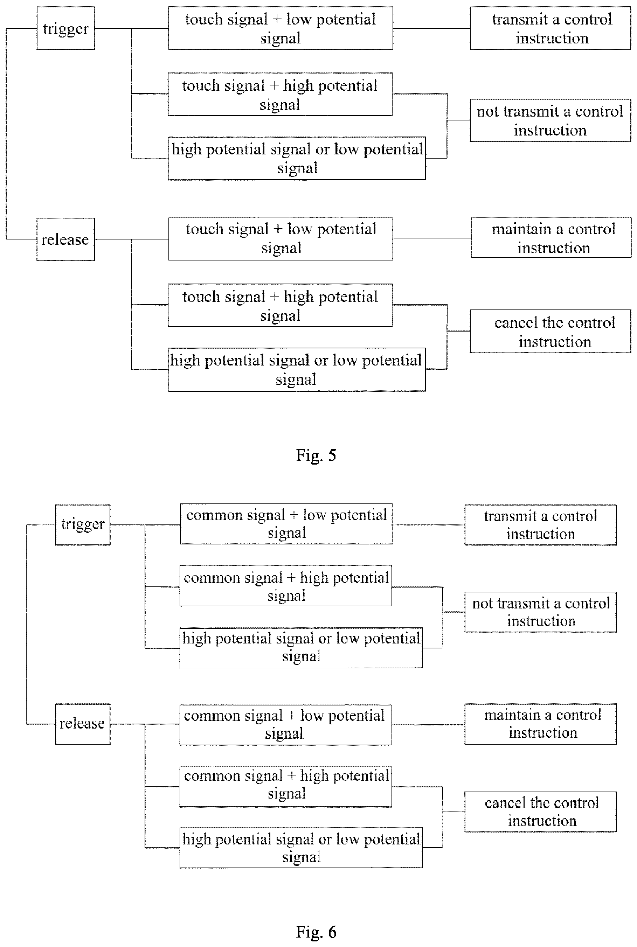

Refer to Fig. 5, in another example embodiment of the disclosure, different from the example embodiments noted supra, the sensing element comprises a touch sensor and a pressure sensor; the touch sensor generates a trigger signal after detecting a touch on the key 100, and the pressure sensor generates a trigger signal after detecting a depressing action on the key 100. The touch sensor may detect a touch between the human body and the key 100. Unintentional touch of the key 100 generally refers to the key being depressed by a foreign object under its center of gravity; when the foreign object touches the key 100, only the pressure sensor is triggered, while the touch sensor does not generate a corresponding trigger signal due to failure of detecting the touch, thereby avoiding generation of a control instruction. This setting may reduce the number of potential change signals and thus may reduce the number of chip module detection pins.

To facilitate user operation, the key comprises a touch key portion and a mechanical key portion, the touch key portion being disposed over the mechanical key, so that the surface of the mechanical key portion has a touch detection function; when the user depresses the mechanical key portion, the touch key portion is also triggered simultaneously, which reduces the number of keys and meanwhile facilitates user operation, eliminating a need to simultaneously trigger two keys.

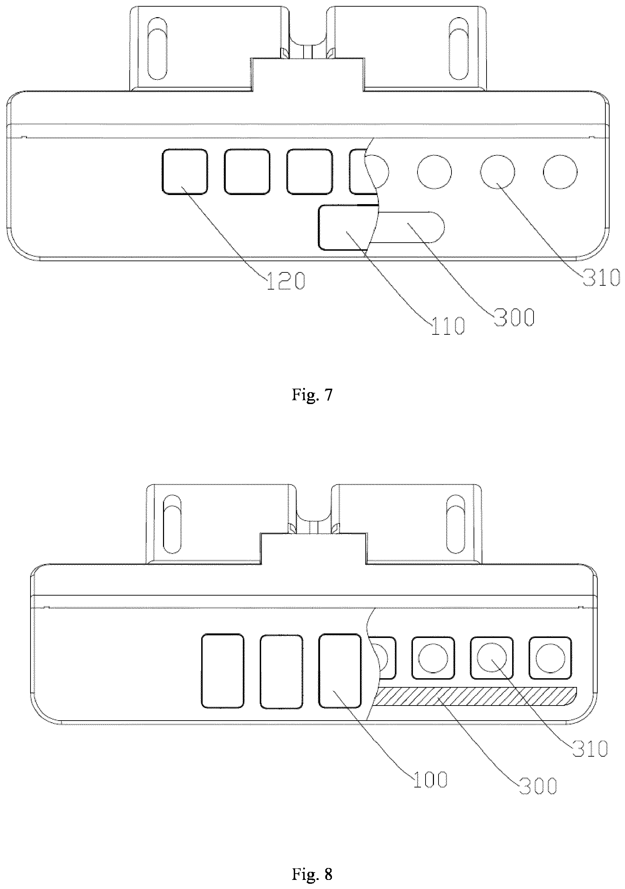

Refer to Figs. 6 and 7, in another example embodiment of the disclosure, different from the embodiments noted *supra,* the control device comprises a plurality of keys 100; different keys 100 correspond to different control instructions, e.g., instructions controlling the desktop to move up, move down, and flip.

In this example embodiment, the plurality of keys include a common key 110, while the rest keys are mechanical/touch keys 120; by depressing the common key 110 and a mechanical/touch key 120, two trigger signals are generated. The plurality of mechanical/touch keys 120 may correspond to different control instructions. Two trigger signals can be generated only when the mechanical/touch key 120 and the common key 110 are simultaneously depressed, which raises the difficulty in unintentional touch-activated movement of the electric desk. With provision of a plurality of keys, if each key were configured with two trigger elements, the chip module would need more pins so as to perform signal detection to the two trigger elements of each of the plurality of keys. However, with the common key, the number of pins of the chip module may be significantly reduced without affecting the palm rejection function of the hand controller.

The sensing element 200 comprises a common trigger element 300 corresponding to the common key 110, and an independent trigger element 310 corresponding to the mechanical/ touch key; the common trigger element 300, when being triggered, generates a common signal, and the independent trigger element 310, when being triggered, generates a trigger signal (i.e., potential change signal noted supra).
In step S10, after the chip module detects a common signal and one trigger signal, the process proceeds to step S20; if no common signal and/or trigger signal are detected, the process proceeds to step S30; if a plurality of trigger signals are detected, the process proceeds to step S30;
in step T10, after the chip module detects a common signal and one trigger signal, the process proceeds to step T20; if no common signal and/or trigger signal are detected, the method proceeds to step T30; if a plurality of trigger signals are detected, the process proceeds to step T30.

Detection of the common signal and one trigger signal indicates one mechanical/ touch key 120 and the common key 110 are operated by the user, and the controller generates a control instruction corresponding to the mechanical/ touch key 120; when a plurality of trigger signals are emitted, it indicates a plurality of mechanical/ touch keys 120 are triggered, which is determined as an unintentional touch.

Different from the embodiments noted supra, in one example embodiment of the disclosure, referring to Fig. 8, the plurality of keys are all mechanical/ touch keys 120; the sensing element comprises one common trigger element 300 and a plurality of independent trigger elements 310 corresponding to the plurality of keys; when one key is depressed, the common trigger element 300 and the independent trigger element 310 are simultaneously triggered to generate two trigger signals.

In normal operation, when one key is depressed, the common trigger element 300 and one independent trigger element 310 may be simultaneously triggered to generate two trigger signals, which only requires the user to depress one key; therefore, the operation is eased.

The common trigger element 300, when being triggered, generates a common signal, and the independent trigger elements 300, when being triggered, generate trigger signals.
In step S10, after the chip module detects a common signal and one trigger signal, the process proceeds to step S20; if no common signal and/or trigger signal are detected, the process proceeds to step S30; if a plurality of trigger signals and/or a plurality of common signals are detected, the process proceeds to step S30;
in step T10, after the chip module detects the common signal and one trigger signal, the process proceeds to step T20; if no common signal and/or trigger signal are detected, the process proceeds to step T30; if a plurality of trigger signals and/or a plurality of common signals are detected, the process proceeds to step T30.

What have been described above are only example embodiments of the present disclosure; however, the protection scope of the present disclosure is not limited thereto. A person skilled in the art should understand that the disclosure includes, but is not limited to, the contents described in the drawings and the embodiments.

The scope of protection is defined solely by the appended claims.

## Claims

1. A method of controlling an electric desk, wherein the electric desk comprises a control device for controlling movement of the electric desk, the control device comprising a key (100), a chip module, and a controller, the control device further comprising a sensing element (200) corresponding to the key (100), the sensing element (200) being triggered by a key (100) depressing action, the sensing element (200), when being triggered normally, emitting two independent trigger signals, the chip module being configured to receive the trigger signals such that the controller transmits a control instruction driving movement of the electric desk;
when the key (100) is depressed, the control method comprises:
S10: detecting, by a chip module, the trigger signals emitted from the sensing element (200), wherein if two trigger signals are detected, the control method proceeds to step S20, and otherwise proceeds to step S30;
S20: transmitting, by a controller, the control instruction;
S30: not transmitting, by a controller, the control instruction;
when the key (100) is released, the control method comprises:
T10: detecting, by the chip module, the trigger signals emitted from the sensing element (200), wherein if two trigger signals are detected, the control method proceeds to step T20, and otherwise if the number of signals received by the chip module is less than two proceeds to step T30;
T20: maintaining, by the controller, the control instruction;
T30: suspending, by the controller, the control instruction and the control instruction is
immediately cancelled to stop the movement of the electric desk,
wherein the sensing element (200) comprises a trigger element, and two triggering ends (210) disposed on the trigger element and corresponding to the key (100), the two triggering ends (210), when contacting the key (100), generating one trigger signal, respectively.

2. The method of controlling an electric desk according to claim 1, wherein in the step S10, if the number of trigger signals detected by the chip module is one or zero, the method proceeds to step S30; in the step T10, if the number of trigger signals detected by the chip module is one or zero, the method proceeds to step T30.

3. The method of controlling an electric desk according to claim 1, wherein the two trigger signals generated by the sensing element (200) are referred to as a first signal and a second signal, respectively;
in the step S10, the chip module detects the second signal after the first signal is detected; if the first signal is not detected, the method directly proceeds to step S30;
in the step T10, the chip module detects the second signal after the first signal is detected; if the first signal is not detected, the method directly proceeds to step T30.

4. The method of controlling an electric desk according to claim 1, wherein the controller issues the control instruction after the chip module detects the two trigger signals for consecutive two times;
in the step S10, after the chip module consecutively detects two trigger signals within a unit time, the method proceeds to step S20; and
the unit time is 0.1s~2s.

5. The method of controlling an electric desk according to any one of claims 1 to 4, wherein the sensing element (200) comprises a touch sensor and a pressure sensor; the touch sensor, after detecting a touch on the key (100), generates a trigger signal; and the pressure sensor, after detecting the key (100) depressing action, generates a trigger signal.

6. The method of controlling an electric desk according to any one of claims 1 to 3, wherein the control device comprises a plurality of mechanical/touch keys (120) and one common key (110), and by simultaneously depressing the common key (110) and one mechanical/touch key (120), two trigger signals are generated.

7. The method of controlling an electric desk according to claim 6, wherein the sensing element (200) comprises a common trigger element (300) corresponding to the common key (110) and independent trigger elements (310) corresponding to the mechanical/ touch keys (120); the common trigger element (300), when being triggered, generates a common signal; and the independent trigger elements (310), when being triggered, generate trigger signals;
in the step S10, after the chip module detects the common signal and one trigger signal, the method proceeds to step S20; if the common signal and/or trigger signal are not detected, the method proceeds to step S30; if a plurality of trigger signals are detected, the method proceeds to step S30; and
in the step T10, after the chip module detects the common signal and one trigger signal, the method proceeds to step T20; if the common signal and/or trigger signal are not detected, the method proceeds to step T30; if a plurality of trigger signals are detected, the method proceeds to step T30.

8. The method of controlling an electric desk according to any one of claims 1 to 3, wherein the control device comprises a plurality of keys (100); the sensing element (200) comprises one common trigger element (300) and a plurality of independent trigger elements (310), the one common trigger element (300) and the plurality of independent trigger elements (310) being set in correspondence to the plurality of keys (100); when a key (100) is depressed, the common trigger element (300) and an independent trigger element (310) are simultaneously triggered to generate two trigger signals.

9. The method of controlling an electric desk according to claim 8, wherein the common trigger element (300), when being triggered, generates a common signal, and the independent trigger elements (310), when being triggered, generate trigger signals;
in the step S10, after the chip module detects the common signal and one trigger signal, the method proceeds to step S20; if no common signal and/or trigger signal are detected, the method proceeds to step S30; if a plurality of trigger signals and/or a plurality of common signals are detected, the method proceeds to step S30;
in the step T10, after the chip module detects the common signal and one trigger signal, the method proceeds to step T20; if no common signal and/or trigger signal are detected, the method proceeds to step T30; if a plurality of trigger signals and/or a plurality of common signals are detected, the method proceeds to step T30.

## Patentansprüche

1. Verfahren zum Steuern eines elektrischen Tischs, wobei der elektrische Tisch eine Steuervorrichtung zum Steuern einer Bewegung des elektrischen Tischs umfasst, wobei die Steuervorrichtung eine Taste (100), ein Chipmodul und eine Steuerung umfasst, wobei die Steuervorrichtung ferner ein Sensorelement (200) umfasst, das der Taste (100) zugeordnet ist, wobei das Sensorelement (200) durch eine Betätigungsaktion der Taste (100) ausgelöst wird, wobei das Sensorelement (200), wenn es normal ausgelöst wird, zwei unabhängige Auslösesignale abgibt, wobei das Chipmodul dazu eingerichtet ist, die Auslösesignale zu empfangen, so dass die Steuerung eine Steueranweisung überträgt, die eine Bewegung des elektrischen Tischs antreibt;
wenn die Taste (100) gedrückt wird, umfasst das Steuerungsverfahren:
S10: Erfassen, durch ein Chipmodul, der von dem Sensorelement (200) abgegebenen Auslösesignale, wobei, wenn zwei Auslösesignale erfasst werden, das Steuerungsverfahren zu Schritt S20 übergeht und andernfalls zu Schritt S30 übergeht;
S20: Übertragen, durch eine Steuerung, der Steueranweisung;
S30: Nichtübertragen, durch eine Steuerung, der Steueranweisung;
wenn die Taste (100) losgelassen wird, umfasst das Steuerungsverfahren:
T10: Erfassen, durch das Chipmodul, der von dem Sensorelement (200) abgegebenen Auslösesignale, wobei, wenn zwei Auslösesignale erfasst werden, das Steuerungsverfahren zu Schritt T20 übergeht und andernfalls, wenn die Anzahl der von dem Chipmodul empfangenen Signale kleiner als zwei ist, zu Schritt T30 übergeht;
T20: Aufrechterhalten, durch die Steuerung, der Steueranweisung;
T30: Aussetzen, durch die Steuerung, der Steueranweisung, wobei die Steueranweisung unmittelbar aufgehoben wird, um die Bewegung des elektrischen Tischs zu stoppen,
wobei das Sensorelement (200) ein Auslöseelement und zwei Auslöseenden (210) umfasst, die an dem Auslöseelement angeordnet sind und der Taste (100) zugeordnet sind, wobei die zwei Auslöseenden (210), wenn sie die Taste (100) kontaktieren, jeweils ein Auslösesignal erzeugen.

2. Verfahren zum Steuern eines elektrischen Tischs nach Anspruch 1, wobei in Schritt S10, wenn die Anzahl der durch das Chipmodul erfassten Auslösesignale eins oder null ist, das Verfahren zu Schritt S30 übergeht; wobei in Schritt T10, wenn die Anzahl der durch das Chipmodul erfassten Auslösesignale eins oder null ist, das Verfahren zu Schritt T30 übergeht.

3. Verfahren zum Steuern eines elektrischen Tischs nach Anspruch 1, wobei die zwei durch das Sensorelement (200) erzeugten Auslösesignale jeweils als ein erstes Signal und ein zweites Signal bezeichnet werden;
wobei in Schritt S10 das Chipmodul das zweite Signal erfasst, nachdem das erste Signal erfasst wurde; wobei, wenn das erste Signal nicht erfasst wird, das Verfahren direkt zu Schritt S30 übergeht;
wobei in Schritt T10 das Chipmodul das zweite Signal erfasst, nachdem das erste Signal erfasst wurde; wobei, wenn das erste Signal nicht erfasst wird, das Verfahren direkt zu Schritt T30 übergeht.

4. Verfahren zum Steuern eines elektrischen Tischs nach Anspruch 1, wobei die Steuerung die Steueranweisung ausgibt, nachdem das Chipmodul die zwei Auslösesignale zweimal nacheinander erfasst hat;
wobei in Schritt S10, nachdem das Chipmodul innerhalb einer Zeiteinheit nacheinander zwei Auslösesignale erfasst hat, das Verfahren zu Schritt S20 übergeht; und
wobei die Zeiteinheit 0,1 s bis 2 s beträgt.

5. Verfahren zum Steuern eines elektrischen Tischs nach einem der Ansprüche 1 bis 4, wobei das Sensorelement (200) einen Berührungssensor und einen Drucksensor umfasst; wobei der Berührungssensor, nachdem er eine Berührung an der Taste (100) erfasst hat, ein Auslösesignal erzeugt; und wobei der Drucksensor, nachdem er die Betätigungsaktion der Taste (100) erfasst hat, ein Auslösesignal erzeugt.

6. Verfahren zum Steuern eines elektrischen Tischs nach einem der Ansprüche 1 bis 3, wobei die Steuervorrichtung eine Mehrzahl von mechanischen/berührungsempfindlichen Tasten (120) und eine gemeinsame Taste (110) umfasst, und wobei durch gleichzeitiges Drücken der gemeinsamen Taste (110) und einer mechanischen/berührungsempfindlichen Taste (120) zwei Auslösesignale erzeugt werden.

7. Verfahren zum Steuern eines elektrischen Tischs nach Anspruch 6, wobei das Sensorelement (200) ein gemeinsames Auslöseelement (300), das der gemeinsamen Taste (110) zugeordnet ist, und unabhängige Auslöseelemente (310), die den mechanischen/berührungsempfindlichen Tasten (120) zugeordnet sind, umfasst; wobei das gemeinsame Auslöseelement (300), wenn es ausgelöst wird, ein gemeinsames Signal erzeugt; und wobei die unabhängigen Auslöseelemente (310), wenn sie ausgelöst werden, Auslösesignale erzeugen;
wobei in Schritt S10, nachdem das Chipmodul das gemeinsame Signal und ein Auslösesignal erfasst hat, das Verfahren zu Schritt S20 übergeht; wobei, wenn das gemeinsame Signal und/oder das Auslösesignal nicht erfasst werden, das Verfahren zu Schritt S30 übergeht; wobei, wenn eine Mehrzahl von Auslösesignalen erfasst wird, das Verfahren zu Schritt S30 übergeht; und
wobei in Schritt T10, nachdem das Chipmodul das gemeinsame Signal und ein Auslösesignal erfasst hat, das Verfahren zu Schritt T20 übergeht; wobei, wenn das gemeinsame Signal und/oder das Auslösesignal nicht erfasst werden, das Verfahren zu Schritt T30 übergeht; wobei, wenn eine Mehrzahl von Auslösesignalen erfasst wird, das Verfahren zu Schritt T30 übergeht.

8. Verfahren zum Steuern eines elektrischen Tischs nach einem der Ansprüche 1 bis 3, wobei die Steuervorrichtung eine Mehrzahl von Tasten (100) umfasst; wobei das Sensorelement (200) ein gemeinsames Auslöseelement (300) und eine Mehrzahl von unabhängigen Auslöseelementen (310) umfasst, wobei das eine gemeinsame Auslöseelement (300) und die Mehrzahl von unabhängigen Auslöseelementen (310) entsprechend der Mehrzahl von Tasten (100) angeordnet sind; wobei, wenn eine Taste (100) gedrückt wird, das gemeinsame Auslöseelement (300) und ein unabhängiges Auslöseelement (310) gleichzeitig ausgelöst werden, um zwei Auslösesignale zu erzeugen.

9. Verfahren zum Steuern eines elektrischen Tischs nach Anspruch 8, wobei das gemeinsame Auslöseelement (300), wenn es ausgelöst wird, ein gemeinsames Signal erzeugt und die unabhängigen Auslöseelemente (310), wenn sie ausgelöst werden, Auslösesignale erzeugen;
wobei in Schritt S10, nachdem das Chipmodul das gemeinsame Signal und ein Auslösesignal erfasst hat, das Verfahren zu Schritt S20 übergeht; wobei, wenn kein gemeinsames Signal und/oder kein Auslösesignal erfasst werden, das Verfahren zu Schritt S30 übergeht; wobei, wenn eine Mehrzahl von Auslösesignalen und/oder eine Mehrzahl von gemeinsamen Signalen erfasst werden, das Verfahren zu Schritt S30 übergeht;
wobei in Schritt T10, nachdem das Chipmodul das gemeinsame Signal und ein Auslösesignal erfasst hat, das Verfahren zu Schritt T20 übergeht; wobei, wenn kein gemeinsames Signal und/oder kein Auslösesignal erfasst werden, das Verfahren zu Schritt T30 übergeht; wobei, wenn eine Mehrzahl von Auslösesignalen und/oder eine Mehrzahl von gemeinsamen Signalen erfasst werden, das Verfahren zu Schritt T30 übergeht.

## Revendications

1. Procédé de commande d'un bureau électrique, dans lequel le bureau électrique comprend un dispositif de commande destiné à commander le mouvement du bureau électrique, le dispositif de commande comprenant une touche (100), un module à puce et un contrôleur, le dispositif de commande comprenant en outre un élément de détection (200) correspondant à la touche (100), l'élément de détection (200) étant déclenché par une action d'enfoncement de la touche (100), l'élément de détection (200), lorsqu'il est déclenché normalement, émettant deux signaux de déclenchement indépendants, le module à puce étant configuré pour recevoir les signaux de déclenchement de sorte que le contrôleur transmette une instruction de commande pilotant le mouvement du bureau électrique ;
lorsque la touche (100) est enfoncée, le procédé de commande comprend :
S10 : la détection, par un module à puce, des signaux de déclenchement émis par l'élément de détection (200), dans lequel si deux signaux de déclenchement sont détectés, le procédé de commande passe à l'étape S20, sinon il passe à l'étape S30 ;
S20 : la transmission, par un contrôleur, de l'instruction de commande ;
S30 : la non-transmission, par un contrôleur, de l'instruction de commande ;
lorsque la touche (100) est relâchée, le procédé de commande comprend :
T10 : la détection, par le module à puce, des signaux de déclenchement émis par l'élément de détection (200), dans lequel si deux signaux de déclenchement sont détectés, le procédé de commande passe à l'étape T20, et dans le cas contraire, si le nombre de signaux reçus par le module à puce est inférieur à deux, il passe à l'étape T30 ;
T20 : le maintien, par le contrôleur, de l'instruction de commande ;
T30 : l'interruption, par le contrôleur, de l'instruction de commande et l'instruction de commande est immédiatement annulée afin d'arrêter le mouvement du bureau électrique,
dans lequel l'élément de détection (200) comprend un élément de déclenchement et deux extrémités de déclenchement (210) disposées sur l'élément de déclenchement et correspondant à la touche (100), les deux extrémités de déclenchement (210) générant respectivement un signal de déclenchement lorsqu'elles entrent en contact avec la touche (100).

2. Procédé de commande d'un bureau électrique selon la revendication 1, dans lequel, à l'étape S10, si le nombre de signaux de déclenchement détectés par le module à puce est égal à un ou à zéro, le procédé passe à l'étape S30 ; à l'étape T10, si le nombre de signaux de déclenchement détectés par le module à puce est égal à un ou à zéro, le procédé passe à l'étape T30.

3. Procédé de commande d'un bureau électrique selon la revendication 1, dans lequel les deux signaux de déclenchement générés par l'élément de détection (200) sont respectivement désignés comme étant un premier signal et un second signal ;
à l'étape S10, le module à puce détecte le second signal une fois le premier signal détecté ; si le premier signal n'est pas détecté, le procédé passe directement à l'étape S30 ;
à l'étape T10, le module à puce détecte le second signal une fois le premier signal détecté ; si le premier signal n'est pas détecté, le procédé passe directement à l'étape T30.

4. Procédé de commande d'un bureau électrique selon la revendication 1, dans lequel le contrôleur émet l'instruction de commande après que le module à puce a détecté les deux signaux de déclenchement à deux reprises consécutives ;
à l'étape S10, une fois que le module à puce a détecté deux signaux de déclenchement consécutifs au cours d'une unité de temps, le procédé passe à l'étape S20 ; et
l'unité de temps est de 0,1 s~2 s.

5. Procédé de commande d'un bureau électrique selon l'une quelconque des revendications 1 à 4, dans lequel l'élément de détection (200) comprend un capteur tactile et un capteur de pression ; le capteur tactile, après avoir détecté un contact sur la touche (100), génère un signal de déclenchement ; et le capteur de pression, après avoir détecté l'action d'enfoncement de la touche (100), génère un signal de déclenchement.

6. Procédé de commande d'un bureau électrique selon l'une quelconque des revendications 1 à 3, dans lequel le dispositif de commande comprend une pluralité de touches mécaniques/tactiles (120) et une touche commune (110), et en appuyant simultanément sur la touche commune (110) et sur une touche mécanique/tactile (120), deux signaux de déclenchement sont générés.

7. Procédé de commande d'un bureau électrique selon la revendication 6, dans lequel l'élément de détection (200) comprend un élément de déclenchement commun (300) correspondant à la touche commune (110) et des éléments de déclenchement indépendants (310) correspondant aux touches mécaniques/tactiles (120) ; l'élément de déclenchement commun (300), lorsqu'il est déclenché, génère un signal commun ; et les éléments de déclenchement indépendants (310), lorsqu'ils sont déclenchés, génèrent des signaux de déclenchement ;
à l'étape S10, une fois que le module à puce a détecté le signal commun et un signal de déclenchement, le procédé passe à l'étape S20 ; si le signal commun et/ou le signal de déclenchement ne sont pas détectés, le procédé passe à l'étape S30 ; si une pluralité de signaux de déclenchement sont détectés, le procédé passe à l'étape S30 ; et
à l'étape T10, une fois que le module à puce a détecté le signal commun et un signal de déclenchement, le procédé passe à l'étape T20 ; si le signal commun et/ou le signal de déclenchement ne sont pas détectés, le procédé passe à l'étape T30 ; si une pluralité de signaux de déclenchement sont détectés, le procédé passe à l'étape T30.

8. Procédé de commande d'un bureau électrique selon l'une quelconque des revendications 1 à 3, dans lequel le dispositif de commande comprend une pluralité de touches (100) ; l'élément de détection (200) comprend un élément de déclenchement commun (300) et une pluralité d'éléments de déclenchement indépendants (310), l'élément de déclenchement commun (300) et la pluralité d'éléments de déclenchement indépendants (310) étant mis en correspondance avec la pluralité de touches (100) ; lorsqu'une touche (100) est enfoncée, l'élément de déclenchement commun (300) et un élément de déclenchement indépendant (310) sont simultanément déclenchés pour générer deux signaux de déclenchement.

9. Procédé de commande d'un bureau électrique selon la revendication 8, dans lequel l'élément de déclenchement commun (300), lorsqu'il est déclenché, génère un signal commun, et les éléments de déclenchement indépendants (310), lorsqu'ils sont déclenchés, génèrent des signaux de déclenchement ;
à l'étape S10, une fois que le module à puce a détecté le signal commun et un signal de déclenchement, le procédé passe à l'étape S20 ; si aucun signal commun et/ou signal de déclenchement n'est détecté, le procédé passe à l'étape S30 ; si une pluralité de signaux de déclenchement et/ou une pluralité de signaux communs sont détectés, le procédé passe à l'étape S30 ;
à l'étape T10, une fois que le module à puce a détecté le signal commun et un signal de déclenchement, le procédé passe à l'étape T20 ; si aucun signal commun et/ou signal de déclenchement n'est détecté, le procédé passe à l'étape T30 ; si une pluralité de signaux de déclenchement et/ou une pluralité de signaux communs sont détectés, le procédé passe à l'étape T30.
